# EUROPEAN PATENT APPLICATION

(11) **EP 4 459 307 A1**
(43) Date of publication of application: **06.11.2024**
(21) Application number: 23171132.6
(22) Date of filing: 02.05.2023
(51) Int. Cl.: G01R 33/28, G01R 33/385, G06N 3/02, G10K 11/175, G10K 11/178

(54) **COMMUNICATION SYSTEM FOR MAGNETIC RESOANNCE IMAGING**

(71) Applicant: Koninklijke Philips N.V., 5656 AG Eindhoven (NL)
(72) Inventor: VAN HELVOORT, Mark, Eindhoven (NL); OUZOUNOV, Sotir Filipov, Eindhoven (NL)
(74) Representative: Philips Intellectual Property & Standards

(57) **Abstract**

The invention provides for a medical system comprising a magnetic resonance imaging communication system. The magnetic resonance imaging communication system comprises a subject microphone configured for acquiring measured audio data from a subject. The magnetic resonance imaging communication system is configured to acquire the measured audio data as a continuous data stream during acquisition of k-space data by a magnetic resonance imaging system. The magnetic resonance imaging communication system further comprises at least one neural network processing module. The at least one neural network processing module is configured to output at least one audio signal in response to receiving the measured audio data as input. The at least one audio signal comprises a subject speech audio signal. The at least one neural network processing module is configured to repeatedly provide the at least one audio signal in response to receiving the continuous data stream.

## Description

### FIELD OF THE INVENTION

The invention relates to magnetic resonance imaging, in particular to verbal communication during the operation of a magnetic resonance imaging system.

### BACKGROUND OF THE INVENTION

A static magnetic field is used by Magnetic Resonance Imaging (MRI) scanners to align the nuclear spins of atoms as part of the procedure for producing images within the body of a patient. This large static magnetic field is referred to as the B0 field or the main magnetic field. The orientation of the nuclear spins is manipulated using a combination of time changing Radio-Frequency (RF) signals and time changing gradient magnetic fields superimposed on the B0 field. The magnetic field gradients are generated using so-called gradient coils. During operation, the gradient coils there are large mechanical forces exerted on them as the gradient magnetic fields are rapidly ramped up and down in strength. This may result in large amounts of audible noise.

International patent publication WO 2023/006456 A1 discloses a magnetic resonance imaging system controlled by a processor. Execution of machine executable instructions causes the processor to receive a selection input of gradient coil pulse commands, to provide the selected commands and at least one value relating to a further parameter to a trained machine learning system, to receive from the machine learning system information as to anti-noise to be generated by a sound transducer to compensate for noise experienced at the ears of a subject in the magnetic resonance imaging system. The machine executable instructions further cause the processor to control the magnetic resonance imaging system with the pulse sequence commands and the set of gradient coil pulse commands for acquisition of the imaging k-space data and to synchronized therewith operate the sound transducer for generating anti-noise using the information as output by the trained machine learning system.

### SUMMARY OF THE INVENTION

The invention provides for a medical system, a computer program, and a method in the independent claims. Embodiments are given in the dependent claims.

As was mentioned above, magnetic resonance imaging system may produce a large amount of noise when operating. This may for example render it difficult or impossible to understand the speech of a subject being examined by a magnetic resonance imaging system. Embodiments may provide for a means of providing a subject speech signal by measuring audio data from a subject microphone and then imputing this into at least one neural network processing module.

In one aspect the invention provides for a medical system that comprises a magnetic resonance imaging system communication system. The magnetic resonance imaging system communication system comprises a subject microphone that is configured for acquiring measured audio data from a subject during operation of a magnetic resonance imaging system. The subject microphone may include an analogue-to-digital converter. The magnetic resonance imaging system communication system is configured to acquire the measured audio data as a continuous data stream during acquisition of k-space data by a magnetic resonance imaging system. The magnetic resonance imaging system communication system further comprises at least one neural network processing module. The at least one neural network processing module is configured to output at least one audio signal. The at least one audio signal comprises a subject speech audio signal. The subject speech audio signal as used herein encompasses an audio signal that has been separated from the measured audio data such that gradient coil noise has been removed or decreased. The measured audio data may contain gradient coil noise which is generated during the acquisition of the k-space data. The at least one neural network is configured to provide the subject speech signal with the gradient coil noise removed or decreased in response to receiving the measured audio data. The at least one neural network processing module is configured to provide the at least one audio signal repeatedly in response to receiving the continuous data stream.

In an embodiment, the measured audio data as a continuous data stream may encompass sending packets of audio data. If the continuous data stream provides the data in packets or in discreet bursts, then the at least one neural network would also provide it in this manner. This may for example result in a slight latency in providing the subject speech audio signal. Latencies in the subject speech audio signal may be insignificant because an operator may be listening to the speech audio signal in a different room or may be listening to the speech audio signal isolated from the normal noise produced by magnetic resonance imaging system. In general, processing the measured audio data as a continuous data stream enables an operator to receive the subject speech audio signal when the subject is speaking and react to it.

Processing the measured audio data as a continuous data stream may further have the benefit that it enables the at least one neural network to provide a gradient noise signal. This may for example be the measured audio data with the subject speech signal removed. The latency of the gradient noise signal in some examples may be low enough that it can be used to perform noise cancellation of the gradient coil noise using subject headphones as is described below.

The at least one neural network processing module may be located in different locations. In some cases, the at least one neural network processing module may be located with the magnet or other components of the magnetic resonance imaging system. In other examples it may be located in a control room for the magnetic resonance imaging system. In yet other examples, it may also be at a remote location where the measured audio data is sent to the at least one neural network processing module and it is then later received back again.

In some embodiments the at least one neural network processing module is implemented in software provided by execution of a computational system in a computer system. This may for example encompass a main processor or processors of a computer or a graphical processing unit. In yet other examples, a specialized hardware implementation of the at least one neural network processing module may be used. The use of a hardware module may be beneficial because this may reduce the latency between the measured audio data and the output subject speech audio signal.

In another embodiment the medical system further comprises a memory storing machine-executable instructions and pulse sequence commands that are configured for controlling the magnetic resonance imaging system to acquire the k-space data. The medical system further comprises a computational system. Execution of the machine-executable instructions causes the computational system to acquire the k-space data by controlling the magnetic resonance imaging system with the pulse sequence commands. Execution of the machine-executable instructions further causes the computational system to control the magnetic resonance imaging communication system to provide the at least one audio signal during acquisition of the k-space data. This embodiment may be beneficial because it may provide for a means of providing real time or near real time audio during the operation of a magnetic resonance imaging system.

In another embodiment the medical system further comprises an operator audio output system that is configured for rendering an operator audio signal. The operator audio signal comprises the subject speech audio signal. This may provide a convenient means for providing the operator of a magnetic resonance imaging system with audio speech from the subject in an intelligible manner. The subject speech audio signal has had the gradient noise removed or sufficiently suppressed by the at least one neural network processing module.

In another embodiment the operator audio signal is a mix of the subject speech audio signal and the gradient noise signal. The subject speech audio signal is louder than the gradient noise signal. In some cases, the subject speech audio signal may be three or four times louder than the gradient noise signal.

This embodiment may be beneficial because when the subject speech audio signal has been separated from the measured audio data by the at least one neural network processing module it may be nonetheless a bit difficult for an operator of the magnetic resonance imaging system to listen to and interpret properly. The measured audio data may comprise several different audio signals that are combined or mixed together. For example, when the gradient coils are running there will be a mix of gradient coil noise and subject speech recorded by the subject microphone. The mechanical process of recording the signal with the subject microphone will cause a spectral overlap at some frequencies which obscure each other. Often times when separate audio signals within the measured audio data are separated or demixed the separate audio signals at the spectral frequencies that overlap may have a lower volume. This may result in a subject speech audio signal that has a lower amplitude at these overlapping frequencies and may make it difficult to understand. Through experimentation it has been found that when one mixes the cleaned subject speech audio signal with a small amount of the original gradient noise signal or the original measured audio data then the speech becomes more intelligible. The gradient noise fills in some of these spectral regions where the amplitude of the speech has been decreased and although noise has been artificially added the speech is more intelligible.

In another embodiment, the at least one audio signal comprises a gradient noise signal. The gradient noise signal as used herein encompasses an audio signal that has been separated from the measured audio data such that subject speech has been removed or decreased.

In another embodiment, the medical system comprises a noise level adjustment which enables control of the relative amplitudes of the subject speech audio signal and the gradient noise signal that are mixed together. This example may be beneficial because it may enable the operator to adjust the level of the gradient noise signal mixed into the subject speech audio signal so that the speech contained in the subject speech signal is easy to understand.

In another embodiment magnetic resonance imaging system communication system is configured for cancelling gradient noise during operation of the magnetic resonance imaging system. For example, this gradient noise is provided by that at least one neural network processing module. It may be used to directly cancel these noises and be used to shield the subject from gradient coil noise.

Since the gradient noise signal has been provided by the at least one neural network processing module it is able to be used to cancel the gradient coil noise produced by the gradient coils. The microphone measures the noise produced by the gradient coils and the speech of the subject. The at least one neural network then provides the gradient noise signal which is the measured audio data with the subject speech removed. The gradient noise signal may be provided directly to the subject via the subject headphones to cancel the gradient coil noise. This may involve adjusting the amplitude, phase, and/or inverting the signal to produce the noise cancellation effect. This is particularly beneficial because it will remove the gradient coil noise, but not the subject speech so that the subject's own speech sounds more natural to the subject.

In another embodiment the magnetic resonance imaging system communication system preferably comprises a subject headphone configured for rendering the subject headphone audio signal to the subject. For example, when the gradient noise signal is inverted and then rendered using the subject headphone, this may be used to cancel all or part of the gradient noise signal.

In another embodiment the subject headphone audio signal further comprises an operator microphone signal. For example, a voice signal from the operator can be mixed into the signal used to cancel the gradient noise. This may enable the subject to hear what the operator says clearly. In addition, the subject audio signal may further comprise any one of the following: a music audio signal, a computer-generated voice message and a pre-recorded voice message. These are all additional audio signals which may be provided to the subject using the headphones also.

In another embodiment the at least one neural network comprises a first neural network processing module and a second neural network processing module. The first neural network processing module is configured for outputting the subject speech audio signal in response to receiving the measured audio data. The second neural network is configured for outputting the gradient noise signal in response to receiving the measured audio data. The first neural network processing module and the second neural network processing module are configured to operate in parallel. There are then two separate neural network processing modules that are operating separately and in parallel. This may be beneficial because each one of them can be tailored to optimize the audio signal that it outputs.

In another embodiment the at least one neural network consists of a single neural network processing module. The at least one neural network processing module is configured for outputting at least one of the subject speech audio signal and the gradient noise signal.

In another embodiment the magnetic resonance imaging communication system is configured to calculate the other of the subject audio signal and the gradient noise signal by subtracting the one of the subject speech audio signal and the gradient noise signal from the measured audio data. This is an operation in a so-called residual mode where one signal is used to calculate the other.

In another embodiment the single neural network processing module comprises a first output layer configured for outputting the subject speech audio signal and the single neural network further comprises a second output layer configured for outputting the gradient noise signal. This embodiment may be beneficial because it may reduce the burden in training the single neural network and may provide for superior operation.

In another embodiment the at least one neural network processing module is a hardware module. This embodiment may be advantageous because the hardware module may be able to provide the at least one audio signal with a lower latency.

In another embodiment the at least one audio signal has a delay with respect to the continuous data stream below a predetermined number of samples of the sampled data. This embodiment may be beneficial because it provides a limit to the latency.

For example, the maximum delay in some embodiments may be 16, 32, 64, 128, 256, 512, 1024, or 2048 samples.

In another embodiment the at least one neural network processing module is implemented as a graphical processing unit.

In another embodiment the at least one neural network processing module is implemented as an FPGA neural network.

In another embodiment the at least one neural network is a neuromorphic processor. The use of a neuromorphic processor may be particularly beneficial as the latency may be minimal in comparison to other solutions.

In another embodiment the at least one neural network processing module is implemented as a microcontroller.

In another embodiment the at least one neural network processing module is implemented as a computer processor.

In another embodiment the at least one neural network processing module is implemented as a recurrent neural network.

In another embodiment the at least one neural network processing module is implemented as a cascade of multiple neural networks.

The training data for the at least one neural network processing module can be obtained by creating it synthetically. The speech of a test subject can be recorded independently from the noise of a magnetic resonance imaging system (gradient coil noise). The two recordings can be mixed together to create test data and either the gradient coil noise and/or the speech can be used as the ground truth data.

In another aspect the invention provides for a computer program comprising machine-executable instructions for execution by a processor controlling a computational system. The computational system is configured for controlling a medical system that comprises a magnetic resonance imaging system communication system. The magnetic resonance imaging system communication system comprises a subject microphone that is configured for acquiring measured audio data from a subject during operation of a magnetic resonance imaging system. The magnetic resonance imaging system communication system is configured to acquire the measured audio data as a continuous data stream during acquisition of k-space data by the magnetic resonance imaging system. The magnetic resonance imaging system communication system further comprises at least one neural network processing module. The at least one neural network processing module is configured to output at least one audio signal. The at least one audio signal comprises a subject speech audio signal in response to receiving the measured audio data as input. The at least one neural network processing module is configured to provide the at least one audio signal continuously in response to receiving the continuous data stream.

Execution of the machine-executable instructions causes the computational system to control the subject microphone to acquire the measured audio data. Execution of the machine-executable instructions further causes the computational system to receive the at least one audio signal in response to inputting the measured audio data into the at least one neural network processing module.

In another aspect the invention provides for a method of operating the medical system. The medical system comprises a magnetic resonance imaging system communication system. The magnetic resonance imaging system communication system comprises a subject microphone that is configured for acquiring measured audio data from a subject during operation of a magnetic resonance imaging system. The magnetic resonance imaging system communication system is configured to acquire the measured audio data as a continuous data stream during acquisition of the k-space data by a magnetic resonance imaging system. The magnetic resonance imaging system communication system further comprises at least one neural network processing module. The at least one neural network processing module is configured to output at least one audio signal. The at least one audio signal comprises a subject speech audio signal in response to receiving the measured audio data as input. The at least one neural network processing module is configured to provide the at least one audio signal continuously in response to receiving the continuous data stream.

The method comprises controlling the subject microphone to acquire the measured audio data. The method further comprises receiving the at least one audio signal in response to inputting the measured audio data into the at least one neural network processing module.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, microphone and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, an audio system such as a loudspeaker, and Head-mounted display.

K-space data is defined herein as being the recorded measurements of radio frequency signals emitted by atomic spins using the antenna of a Magnetic resonance apparatus during a magnetic resonance imaging scan.

A Magnetic Resonance Imaging (MRI) image or MR image is defined herein as being the reconstructed two- or three-dimensional visualization of anatomic data contained within the k-space data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1; and
Fig. 3 illustrates a further example of a medical system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

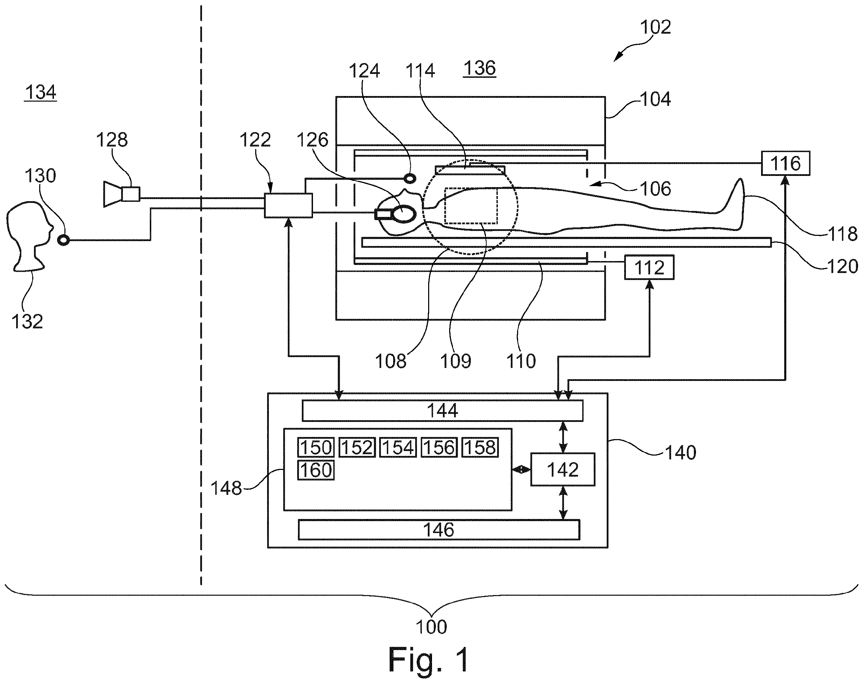

Fig. 1 illustrates an example of a medical system 100. The medical system is shown as comprising a magnetic resonance imaging system 102, a computer system 140 and a magnetic resonance imaging system communication system 122. Some of the components are shown as being split between a control room 134 and a magnet room 136. The division of the components these two locations is however arbitrary and is only here for the sake of illustration.

The magnetic resonance imaging system 102 comprises a magnet 104. The magnet 104 is a superconducting cylindrical type magnet with a bore 106 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A field of view 109 is shown within the imaging zone 108. The magnetic resonance data that is acquired typically acquired for the field of view 109. A subject 118 is shown as being supported by a subject support 120 such that at least a portion of the subject 118 is within the imaging zone 108 and the predetermined region of interest 109.

Within the bore 106 of the magnet there is also a set of magnetic field gradient coils 110 which is used for acquisition of preliminary magnetic resonance data to spatially encode magnetic spins within the imaging zone 108 of the magnet 104. The magnetic field gradient coils 110 connected to a magnetic field gradient coil power supply 112. The magnetic field gradient coils 110 are intended to be representative. Typically, magnetic field gradient coils 110 contain three separate sets of coils for spatially encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio-frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio-frequency coil 114 is connected to a radio frequency transceiver 116. The radio-frequency coil 114 and radio frequency transceiver 116 may be replaced by separate transmit and receive coils and a separate transmitter and receiver. It is understood that the radio-frequency coil 114 and the radio frequency transceiver 116 are representative. The radio-frequency coil 114 is intended to also represent a dedicated transmit antenna and a dedicated receive antenna. Likewise, the transceiver 116 may also represent a separate transmitter and receivers. The radio-frequency coil 114 may also have multiple receive/transmit elements and the radio frequency transceiver 116 may have multiple receive/transmit channels. For example, if a parallel imaging technique such as SENSE is performed, the radio-frequency could 114 will have multiple coil elements.

Within the bore 106 of the magnet 104 it can be seen that there is a subject microphone system 124 that is positioned near the mouth of the subject 118 so as to record the speech of the subject 118. The subject microphone system 124 is shown as being connected to the magnetic resonance imaging system communication system 122. The magnetic resonance imaging system communication system 122 is further shown as comprising an optional subject headphones 126 that are able to render audio signals to the subject 118. The magnetic resonance imaging system communication system 122 is also shown as optionally comprising an operator audio output system 128 and an operator microphone system 130. The operator audio output system 128 is able to render audio signals to the operator 132. The operator microphone system 130 is able to record speech or audio from the operator 132.

Within MRI there is the issue that the communication between the operator 132 and the subject 118 is difficult because the operator 132 is normally acoustically isolated from the magnetic resonance imaging system 102 during active scanning to prevent acoustic stress for the operator 132. Examples may enable active communication from the patient to the operator during active scan, without the burden of the operator being exposed to acoustic noise from the gradient system through the communication channel. In addition, an acoustic signal may in some examples be used to drive an anti-noise system can be extracted in real-time without the need for additional input sensors are a complicate interface to the real-time scan software. In principle, a stand-alone communication system can be build. In case of auto-voice the existing interface can be reused. The medical system 100 is further shown as comprising a computer 130. The computer 130 is intended to represent one or more computing or computational devices located at one or more locations. The computer 130 is shown as containing a computational system 132. The computational system 132 is intended to represent one or more computational systems that could for example be one or more processing cores located at one or more locations. Various combinations of computational systems 132 and/or computers 130 could be connected and work together cooperatively using a network. The computational system 132 is shown as being in communication with a hardware interface 134, a user interface 136, and a memory 138. The hardware interface 134 is an interface which enables the computational system 132 to communicate with and/or control other components of the medical system 100 such as the magnetic resonance imaging system 102. The user interface 136 is a user interface that enables an operator of the medical system 100 to control and operate the medical system 100. The memory 138 is intended to represent various types of memory which may be in communication with the computational system 132. The transceiver 116, the gradient controller 112, and the magnetic resonance imaging communication system 122 are shown as being connected to the hardware interface 106 of the computer system 102.

The memory 138 is shown as containing machine-executable instructions 140. The machine-executable instructions 140 enable the computational system 132 to perform basic tasks such as image processing, control of the magnetic resonance imaging system 102 and various computational and data manipulation tasks. The memory 138 is further shown as containing pulse sequence commands 142.

The multiple neural networks may be implemented in different ways. In some examples the magnetic resonance imaging system communication system 122 may contain the at least one neural network processing module. It could for example be implemented as hardware modules. In other examples, the magnetic resonance imaging system communication system 122 may comprise a controller or other computing system and implement the at least one neural network processing module as software. In other examples the computer 140 could receive audio streams from the magnetic resonance imaging system communication system 122 and host the at least one neural network processing module as software.

The memory 148 is shown as containing machine-executable instructions 150. These instructions 150 enable the computational system 142 to control the operation and function of the medical system 100. The memory 148 is further shown as containing pulse sequence commands 152. The pulse sequence commands are commands which enable the computational system 142 to control the magnetic resonance imaging system 102 to acquire k-space data. The memory 148 is further shown as containing k-space data 154 that was acquired by controlling the magnetic resonance imaging system 102 with the pulse sequence commands 152. The memory 148 is further shown as optionally containing the measured audio data 156.

In some embodiments any known subject microphone 124 that picks-up both the speech and the acoustic gradient noise (which actually is the root cause for the problem related to communication between patient and operator).

In some instances the magnetic resonance imaging system communication system 122 handles the various audio streams independent of the computer. In this alternative the memory 148 is also shown as containing the at least one neural network processing module 158, the subject speech audio signal 160 and the gradient noise signal 162. When the measured audio data 156 is input into the at least one neural network processing module 158 it outputs the subject speech audio signal 160 and optionally the gradient noise signal 162. An inversion of the gradient noise signal 162 may be rendered using the subject headphones 126 to cancel noise from the gradient coils 110 during the acquisition of the k-space data 154. The subject speech audio signal 160 may be rendered using the optional operator audio output system 128 to provide speech of the subject 118 to the operator 132. The operator microphone system 130 may also be used to provide an audio signal which is mixed with the gradient noise signal 162 to provide speech from the operator 132 to the subject 118.

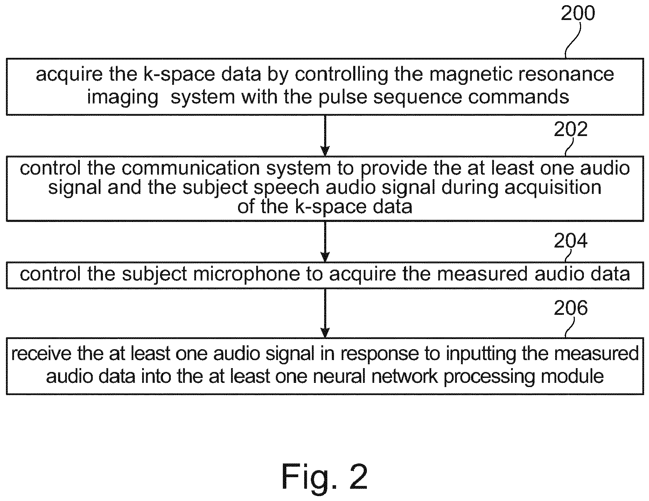

Fig. 2 shows a flowchart which illustrates a method of operating the medical system 100 of Fig. 1. First, in step 200, the k-space data 154 is acquired by controlling the magnetic resonance imaging system 102 with the pulse sequence commands 152. Next, in step 202, the magnetic resonance imaging communication system 122 is controlled to provide the at least one audio signal during the acquisition of the k-space data 154. Step 202 may involve several sub-steps such as steps 204 and 206. In step 204 the subject microphone 124 is controlled to acquire the measured audio data 156 during the acquisition of the k-space data 154. And finally, in step 206, the at least one audio signal is received in response to inputting the measured audio data 156 into the at least one neural network processing module 158.

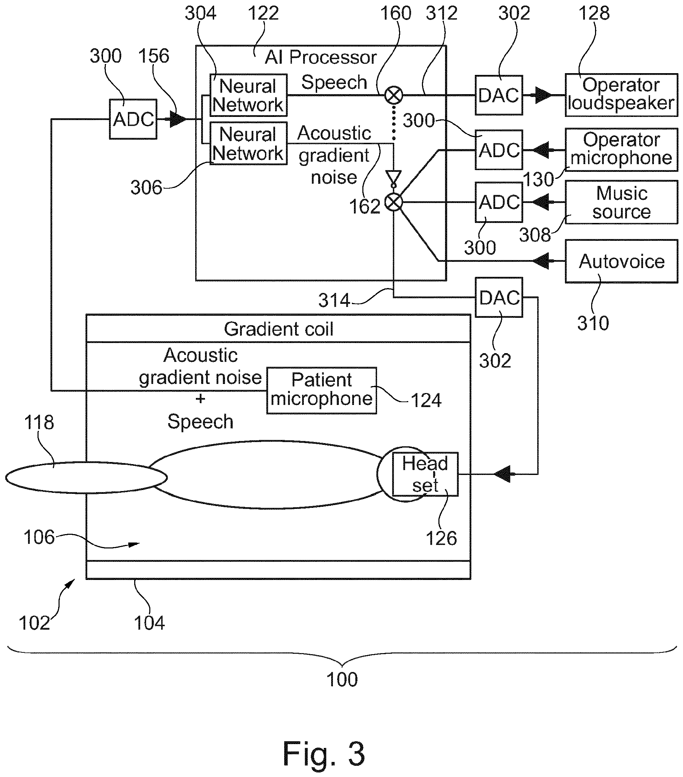

Fig. 3 shows a further view of the medical system 100. In this example the functionality of the magnetic resonance imaging system communication system 122 is illustrated in detail. The patient microphone 124 near the subject 118 is connected to an analogue-to-digital converter 300 which provides the measured audio data 156. In this example it is input into a first neural network processing module 304 and a second neural network processing module 306. In response, the first neural network processing module 304 outputs the subject speech audio signal 160. This is then fed to a digital-to-analogue converter 302, which is then connected to the operator loudspeaker 128. The subject speech audio signal 160 could be rendered directly by the operator audio output system 128 or an additional amount of gradient noise signal 162 could be mixed in with it to produce an operator audio signal 312.

The second neural network processing module 306 outputs the gradient noise signal 162. This is then inverted and may be provided as the subject headphone audio signal 314. The subject headphone audio signal 314 is then rendered by another digital-to-analogue converter 302 connected to the subject headphones 126. This has the effect of cancelling noises generated by the gradient coils. In addition to the inverted gradient noise signal 162 the subject headphone audio signal 314 may also comprise a contribution from an operator microphone 130, a music source 308, or additional pre-recorded or computer-generated speech signals 310.

The first 304 and second 306 neural network processing modules may be implemented as hardware neural network processing modules. As was discussed above, these two neural network processing modules 304, 306 may also be implemented as software. In some cases, there is just a single neural network processing module 304. In this case, there may be a separate output layer for the subject speech audio signal 160 and the gradient noise signal 162. Some embodiments may use a low-latency neuromorphic processor to run the two neural networks simultaneously. One which outputs the pure speech signal and one which outputs the pure acoustic gradient noise, based from a common input signal.

The output of the acoustic gradient noise channel can inverted and added to the selected audio source (operator microphone, music or autovoice (a pre-recorded voice or computer generated voice) to mitigate the direct acoustical noise perceived by the patient. Note that also cryocooler noise can be filtered out with the same system.

For neural models the availability of training and testing data is at utmost importance for feasibility and reliability of systems depending on them In this application data can gathered very easily. Training data will consist of speech recording, without active scanning (no acoustic gradient noise) and of recording acoustic gradient noise without speech. In both cases the actual patient microphone and existing communication infrastructure is used. When "fully clean speech" is not the best for operator perception, the speech training data can be mixed (analog or digital) with a weighted acoustic gradient noise recording. For test data either speech and acoustic gradient noise are mixed offline (with a high weighing factor of the acoustic gradient noise), or additional recordings are used for capturing speech during scan.

In Fig. 3, the first 304 and second 306 neural network processing modules by be implemented as neuromorphic processors. With neuromorphic processors it is possible to execute two neural networks in parallel in real-time. One network is trained to recognize speech, the other network is trained to recognize gradient noise. Effectively, this allows removal of acoustic gradient noise when the patient speaks to the operator during scanning (in state-of-the-art for ergonomic reasons communication channel is closed during scan). In addition, the gradient noise signal can be used to drive noise-cancellation for the patient, without additional sensor to monitor gradient noise or use of system information on gradient pulses.

In this example, this signal is digitized and fed in to, in some embodiments, two neural networks 304, 306. One neural network is trained to generate a pure speech sample 312 and the other neural network is trained to output the acoustic gradient noise 162without speech. These models are implemented on an AI processor which is capable of executing them in real-time (i.e., ultralow latency). These processors are currently available as prototypes/demonstrators, but will become available in larger numbers coming year. From analog noise reduction it is known that removing all background noise does not always give the best perception for the human ear. Therefor a digital mixer is added to the speech channel to add a weighted acoustic gradient noise. In reality, when a fix amount of background is sufficient, this should be implementable in the neural model itself by adjusting the training data.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: magnetic resonance imaging system
- 104: magnet
- 106: bore of magnet
- 108: imaging zone
- 109: field of view
- 110: magnetic field gradient coils
- 112: magnetic field gradient coil power supply
- 114: radio-frequency coil
- 116: transceiver
- 118: subject
- 120: subject support
- 122: magnetic resonance imaging system communication system
- 124: subject microphone system
- 126: subject headphones
- 128: operator audio output system
- 130: operator microphone system
- 132: operator
- 134: control room
- 136: magnet room
- 140: computer
- 142: computational system
- 144: hardware interface
- 146: user interface
- 148: memory
- 150: machine executable instructions
- 152: pulse sequence commands
- 154: k-space data
- 156: measured audio data
- 158: alternative neural network modules
- 160: subject speech audio signal
- 162: gradient noise signal
- 200: acquire the k-space data by controlling the magnetic resonance imaging system with the pulse sequence commands
- 202: control the magnetic resonance imaging communication system to provide the at least one audio signal during acquisition of the k-space data
- 204: control the subject microphone to acquire the measured audio data
- 206: receive the at least one audio signal in response to inputting the measured audio data into the at least one neural network processing module
- 300: analog to digital converter
- 302: digital to analog converter
- 304: first neural network processing module
- 306: second neural network processing module
- 308: music source
- 310: prerecorded or computer generated speech
- 312: operator audio signal
- 314: subject headphone audio signal

## Claims

1. A medical system comprising a magnetic resonance imaging communication system, wherein the magnetic resonance imaging communication system comprises:
- a subject microphone configured for acquiring measured audio data from a subject during operation of a magnetic resonance imaging system, wherein the magnetic resonance imaging communication system is configured to acquire the measured audio data as a continuous data stream during acquisition of k-space data by a magnetic resonance imaging system;
- at least one neural network processing module, wherein the at least one neural network processing module is configured to output at least one audio signal in response to receiving the measured audio data as input, wherein the at least one audio signal comprises a subject speech audio signal, wherein the at least one neural network processing module is configured to repeatedly provide the at least one audio signal in response to receiving the continuous data stream.

2. The medical system of claim 1, wherein the medical system further comprises:
- a memory storing machine executable instructions and pulse sequence commands configured for controlling the magnetic resonance imaging system to acquire the k-space data;
- a computational system, wherein execution of the machine executable instructions causes the computational system to:
- acquire (200) the k-space data by controlling the magnetic resonance imaging system with the pulse sequence commands; and
- control (202) the magnetic resonance imaging communication system to provide the at least one audio signal during acquisition of the k-space data.

3. The medical system of claim 1 or 2, wherein the medical system further comprises an operator audio output system configured for rendering an operator audio signal, wherein the operator audio signal comprises the subject speech audio signal

4. The medical system of claim 3, wherein the at least one audio signal comprises a gradient noise signal, wherein the operator audio signal is a mix of the subject speech audio signal and the gradient noise signal, and wherein the subject speech audio signal is louder than the gradient noise signal.

5. The medical system of any one of the preceding claims, wherein the at least one audio signal comprises a gradient noise signal, wherein the magnetic resonance imaging communication system is configured for cancelling gradient noise during operation of the magnetic resonance imaging system, and wherein the magnetic resonance imaging communication system preferably comprises a subject headphone configured for rendering the subject headphone audio signal to the subject.

6. The medical system of claim 5, wherein the subject headphone audio signal further comprises any one of the following mixed with the inverted gradient noise signal: an operator microphone signal, a music audio signal, and a computer generated voice message, and a pre-recorded voice message.

7. The medical system of any one of the preceding claims, wherein the at least one neural network comprises a first neural network processing module and a second neural network processing module, wherein the first neural network processing module is configured for outputting the subject speech audio signal in response to receiving the measured audio data, wherein the second neural network is configured for outputting the gradient noise signal in response to receiving the measured audio data, and wherein the first neural network processing module and the second neural network processing module are configured to operate in parallel.

8. The medical system of any one of claims 1 through 5, wherein the at least one neural network consists of a single neural network processing module, wherein the at least one neural network processing module is configured for outputting at least one of the subject speech audio signal and the gradient noise signal.

9. The medical system of claim 8, wherein any one of the following:
- the magnetic resonance imaging communication system is configured for calculating the other of the subject audio signal and the gradient noise signal by subtracting the one of the subject speech audio signal and the gradient noise signal from the measured audio data; and
- the single neural network processing module comprises a first output layer configured for outputting the subject speech audio signal, and wherein the single neural network further comprises a second output layer configured for outputting the gradient noise signal.

10. The medical system of any one of the preceding claims, wherein the at least one audio signal has a delay to the continuous data stream below a predetermined number of samples of the sampled data.

11. The medical system of any one of the preceding claims, wherein the at least one neural network processing module is a hardware module.

12. The medical system of any one of the preceding claims, wherein the at least one neural network processing module is implemented as any one of the following: a graphical processing unit, a FPGA neural network, a neuromorphic processor, a microcontroller, and a computer processor.

13. The medical system of any one of the preceding claims, wherein the at least one neural network processing module is implemented as any one of the following: a recurrent neural network, and a cascade of multiple neural networks.

14. A computer program comprising machine executable instructions for execution by a processor controlling a computational system, wherein the computational system is configured for controlling a medical system that comprises a magnetic resonance imaging communication system, wherein the magnetic resonance imaging communication system comprises:
- a subject microphone configured for acquiring measured audio data from a subject during operation of a magnetic resonance imaging system, wherein the magnetic resonance imaging communication system is configured to acquire the measured audio data as a continuous data stream during acquisition of k-space data by the magnetic resonance imaging system;
- at least one neural network processing module, wherein the at least one neural network processing module is configured to output at least one audio signal in response to receiving the measured audio data as input, wherein the at least one audio signal comprises a subject speech audio signal, wherein the at least one neural network processing module is configured to repeatedly provide the at least one audio signal in response to receiving the continuous data stream;
Wherein execution of the machine executable instructions causes the computational system to:
- control (204) the subject microphone to acquire the measured audio data; and
- receive (206) the at least one audio signal in response to inputting the measured audio data into the at least one neural network processing module.

15. A method of operating a medical system, wherein the medical system comprising a magnetic resonance imaging communication system, wherein the magnetic resonance imaging communication system comprises:
- a subject microphone configured for acquiring measured audio data from a subject during operation of a magnetic resonance imaging system, wherein the magnetic resonance imaging communication system is configured to acquire the measured audio data as a continuous data stream during acquisition of k-space data by a magnetic resonance imaging system;
- at least one neural network processing module, wherein the at least one neural network processing module is configured to output at least one audio signal in response to receiving the measured audio data as input, wherein the at least one audio signal comprises a subject speech audio signal, wherein the at least one neural network processing module is configured to repeatedly provide the at least one audio signal in response to receiving the continuous data stream;
Wherein the method comprises:
- controlling (204) the subject microphone to acquire the measured audio data; and
- receiving (206) the at least one audio signal in response to inputting the measured audio data into the at least one neural network processing module.
